# EUROPÄISCHE PATENTSCHRIFT

(11) **EP 1 906 464 B1**
(45) Veröffentlichungstag und Bekanntmachung des Hinweises auf die Patenterteilung: **27.10.2010**
(21) Anmeldenummer: 07102716.3
(22) Anmeldetag: 20.02.2007
(51) Int. Cl.: H01L 41/053

(54) **Piezoaktor mit einer Ummantelung, zur Anordnung in einem Piezoinjektor**
Piezo actuator with a jacket for placing in a piezo injector
Actuateur piézo-éléctrique doté d'une gaine, destiné à l'insertion dans un piézo-injecteur

(30) Priorität: 27.09.2006 DE 102006045663
(43) Veröffentlichungstag der Anmeldung: 02.04.2008
(73) Patentinhaber: ROBERT BOSCH GMBH, 70442 Stuttgart (DE)
(72) Erfinder: Heinz, Rudolf, 71272, Renningen (DE); Kienzler, Dieter, 71229, Leonberg (DE); Schaich, Udo, 70378, Stuttgart (DE)

(56) Entgegenhaltungen:
- DE-A1-102005 024 710
- US-A- 4 553 059

## Beschreibung

### Stand der Technik

Die Erfindung betrifft einen mit einer Hülse ummantelten, beispielsweise von flüssigen Medien umströmten Piezoaktor, der in einem Piezoinjektor zur zeitpunkt- und mengengenauen Dosierung von Kraftstoff für einen Verbrennungsmotor einsetzbar ist, nach den gattungsgemäßen Merkmalen des Hauptanspruchs.

Ein solcher Piezoinjektor besteht im Wesentlichen aus einem Haltekörper und dem in dem Haltekörper angeordneten Piezoaktor, der zwischen einem Aktorkopf und einem Aktorfuß angeordnete übereinandergestapelte Piezoelemente aufweist.

Es ist an sich bekannt, dass zum Aufbau des zuvor erwähnten Piezoaktors die Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor ist ein Stapel mehrerer elektrisch und mechanisch miteinander gekoppelter Piezoelemente vorhanden, der über einen Aktorfuß und einen Aktorkopf unter Vorspannung zwischen zwei Anschlägen gehalten ist. Jede Piezolage ist zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist eine indirekt vom Piezoaktor gesteuerte Düsennadel vorhanden, wobei der Piezoaktor über eine hub- und temperaturausgleichende Hülse-Membran-Anordnung als Ummantelung direkt oder indirekt vom Druck des Kraftstoffs umgeben ist, der in solchen Niederdrucksystemen bei ca. 60 bar liegt.

Auf CR-Injektoren mit direkter Steuerung der Düsennadel ist dieses bekannte Konzept jedoch nicht ohne weiteres übertragbar, da hier der Piezoaktor im Hochdruckbereich des Kraftstoffs betrieben wird und eine starre Hülse-Membran-Anordnung als Ummantelung den hohen Systemdrücken und den höheren Hubbewegungen des Piezoaktors unter den zur Verfügung stehenden Platzverhältnissen im Piezoinjektor nicht standhalten würde.

Um eine elektrische und mechanische Isolierung des Piezoaktors zu erreichen, wird oft auch eine flexible Ummantelung des Piezoaktors vorgeschlagen. Aus der DE 10230032 A1 ist zur Vermeidung der zuvor beschriebenen Nachteile eine Anordnung mit einem Piezoaktor in umströmenden Medien bekannt, bei der die Piezoelemente in einer formveränderlichen Isolationsmasse vergossen sind, die wiederum in einem seitlich und am oberen und unteren Ende gegenüber dem Medium fest verschlossenen Gehäusemantel eingebracht ist.

In der Schrift WO 2006/128749 A, die den Stand der Technik nach Art. 54(3) EPÜ beschreibt, ist ein Piezoaktor mit einem ihn umfassenden Dehnschlauch offenbart, wobei zur Fixierung des Dehnschlauchs ein Befestigungsring vorgesehen ist, der den Dehnschlauch radial gegen einen Bereich eines Übergangsstückes mit einer Befestigungskraft beaufschlagt.

### Offenbarung der Erfindung

Die Erfindung geht von einem eingangs beschriebenen Piezoaktor mit Piezoelementen aus, die zwischen einem Aktorkopf und einem Aktorfuß eingespannt sind, wobei eine mindestens die Piezoelemente umgebende Hülse als Bestandteil der Ummantelung vorhanden ist. Erfindungsgemäß ist die Hülse eine Kunststoffhülse, die am zylindrischen Aktorkopf und/oder am Aktorfuß mit einem zylindrischen Klemmring eingefasst ist. Der jeweilige Klemmring kann ein Metallteil oder ein Kunststoffteil sein, das mit zur Einfassung der Kunststoffhülse geeigneten, insbesondere auch verformbaren Klemmnasen ausgestattet ist und auf den jeweiligen Aktorkopf und/oder Aktorfuß aus Stahl aufgeschoben, aufgepresst oder aufgeschrumpft und damit fest gehalten ist.

Der vorgeschlagene CR-Injektor kann dabei in vorteilhafter Weise so aufgebaut werden, dass eine direkt vom Piezoaktor gesteuerte Düsennadel vorhanden ist, wobei die Steuerung ein oder zweistufig erfolgen kann. Zwischen dem Piezoaktor und der Düsennadel sitzt dabei lediglich ein Koppler mit einer hydraulischen Übersetzung, sodass die Nadelbewegung direkt übersetzt, der durch den Piezoaktor bewirkten Bewegung folgen kann.

Mit der erfindungemäßen Anbringung der Kunststoffhülse ist auf einfache Weise der Piezoaktor, welcher sich im Inneren des Haltekörpers befindet, vor schädlichen Flüssigkeiten, wie Diesel, Wasser, RME als herkömmliche Arten von Biodiesel oder sonstigen leitenden Substanzen sowie Partikeln, Schwebstoffen und den vorherrschenden hohen Drücken aus diesen Substanzen und deren Druck- und Temperaturschwankungen geschützt.

Zum Einsatz können hier insbesondere flexible Kunststoffhülsen kommen, welche aufgeschrumpft bzw. auf andere Art und Weise der Bauteilekontur angeglichen werden können. Die Kunststoffhülsen erzielen in sich die nötige Dichtwirkung gegenüber den Piezoaktoren und stellen einen zusätzlichen Hub- und Temperaturausgleich in dem hier erforderlichen Bereich von -40 bis +160°C sicher. Um eine sichere Dichtwirkung am Bauteileverbund zu erzielen, ist die Kunststoffhülse durch die erfindungsgemäßen Klemmringe an den offenen Enden abgedichtet bzw. gegen einen Medieneintritt verschlossen.

Erfindungsgemäß ist der jeweilige Klemmring vorzentriert oder vororientiert und zusätzlich am Aktorkopf und/oder Aktorfuß verschweißt verlätet oder verklebt. Insbesondere beim Einsatz von Schrumpfschläuchen als Kunststoffhülse kann die Kontur des Aktorkopfs und/oder des Aktorfußes in Richtung der Piezoelemente derart verjüngt sein, dass sich die aufgeschrumpfte Kunststoffhülse daran leicht anschmiegt.

Ferner können der Aktorfkopf und/oder der Aktorfuß im Bereich oder in der Nähe der Klemmung mit dem Klemmring zumindest teilweise eine selbsthemmende Oberfläche aufweisen, wobei die selbsthemmende Oberfläche zum Beispiel aus einer Glaseinschmelzung oder aus ringförmigen Absätzen oder Vertiefungen bestehen kann. Es ist hierbei auch möglich, dass der jeweilige Klemmring auf der dem Aktorkopf und/oder dem Aktorfuß zugewandten Seite eine weiche Beschichtung, insbesondere aus Gold, aufweist.

Bei einer weiteren Ausführungsform der Erfindung kann der jeweilige Klemmring auf einem konisch, auf der den Piezoelementen abgewandten Seite, abgeschrägten Aktorkopf und/oder Aktorfuß aufliegen. Es ist auch besonders vorteilhaft, wenn mindestens eine Klemmnase des jeweiligen Klemmrings Widerhaken, Beiß- oder Dichtkanten aufweist, die ein Herausrutschen der Kunststoffhülse aus dem Klemmring verhindern.

Eine sichere Befestigung der Kunststoffhülse ist auch dadurch erreichbar, dass die mindestens eine äußere Klemmnase vor dem Einführen der Kunststoffhülse nach außen gebogen ist und nach dem Einführen der Kunststoffhülse durch Verstemmen auf die Kunststoffhülse gedrückt wird. Ebenfalls sicher ist eine Befestigungsart, bei der die Kunststoffhülse im Bereich des Einschlusses durch den jeweiligen Klemmring eine vorgefertigte oder nachträglich herbeigeführte Verdickung aufweist, die in einem entsprechend geformten Hohlraum des Klemmringes zu liegen kommt.

Zusammenfassend ist festzustellen, dass mit der Erfindung ein kostengünstiges, einfaches und dauerhaftes Abdichten der Enden einer Kunststoffhülse zur Verhinderung von Kraftstoffeintritt bzw. Eintritt von aktorschädigenden Substanzen bei einem im Hochdruckbereich einer Flüssigkeit arbeitenden Piezoaktor über eine lange Lebensdauer erreicht ist. Durch die Form bzw. die federnden oder sonstigen vorgeschlagenen Eigenschaften der Klemmnasen des jeweiligen Klemmringes oder durch das Verstemmen der Klemmringnasen mit der Kunststoffhülse wird ein Anpressen der Kunststoffhülse an den Aktorkopf und/oder den Aktorfuß aus Metall und damit eine gute Dichtwirkung erreicht.

Kurze Beschreibung der Zeichnungen

Ausführungsbeispiele des erfindungsgemäßen Piezoaktors werden anhand der Zeichnungen erläutert. Es zeigen:
- Figur 1: einen Schnitt durch einen Piezoinjektor mit einem Piezoaktor nach dem Stand der Technik,
- Figur 2a und 2b: eine erste erfindungsgemäße Ausführung eines Klemmrings als Verstemmring zur Befestigung einer Kunststoffhülse auf einem Piezoaktor,
- Figur 3: eine Abwandlung der Anordnung des Klemmringes nach den Figur 2a und 2b mit einer Anbringung auf einer Abschrägung eines Aktorfußes,
- Figur 4: eine Abwandlung der Anordnung des Klemmringes nach den Figur 2a und 2b mit einer zusätzlichen Schweiß- oder Lötnaht,
- Figur 5a bis 5c: Ausführungsbeispiele mit einem Klemmring mit einem Hohlraum zur Aufnahme einer Verdickung der Kunststoffhülse,
- Figuren 6a bis 6c: weitere Ausführungsbeispiele mit einem Klemmring mit zwei Klemmnasen und eine in die dadurch entstandene Nut als Vorzentrierung eingeschobene Kunststoffhülse im ungeschrumpften und im aufgeschrumpften Zustand,
- Figur 7: Ausführungsbeispiele des Klemmringes mit Widerhaken oder Wülsten,
- Figur 8: Ausführungsbeispiele des Klemmringes mit unterschiedlichen Beiß- oder Dichtkanten.

### Ausführungsformen der Erfindung

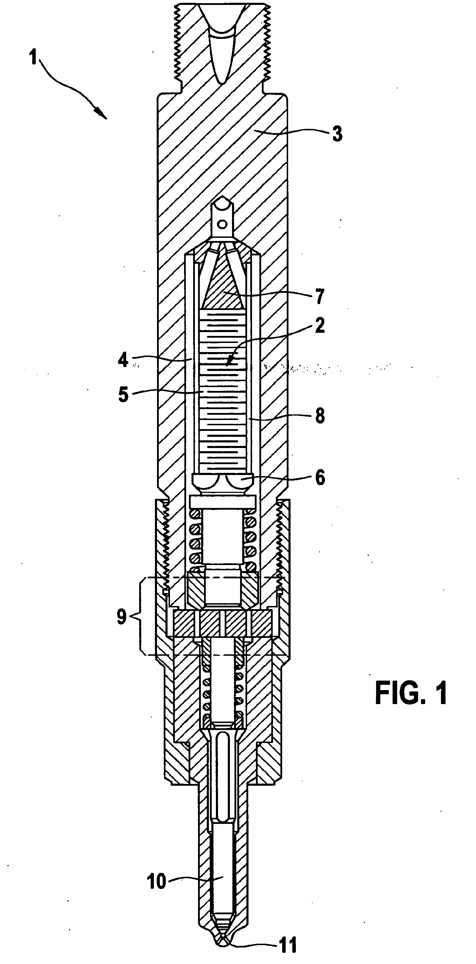

In Figur 1 ist ein prinzipieller Aufbau eines Piezoinjektors 1 mit einem Piezoaktor 2 nach dem Stand der Technik gezeigt, der beispielsweise zur Nadelhubsteuerung in einem Einspritzsystem für Kraftstoff bei einem Verbrennungsmotor eingesetzt werden kann. Im oberen Teil ist ein Haltekörper 3 vorhanden, der in seinen geometrischen Abmessungen im Wesentlichen an den jeweiligen Verwendungszweck und den spezifischen Einsatzort angepasst werden kann. Durch den Haltekörper 3 werden mit einer spezifisch angepassten Steckerausführung die elektrische Spannung zur Ansteuerung von in einem Innenraum 4 des Haltekörpers 3 angeordneten übereinandergestapelten Piezoelementen 5 geführt, die zusammen mit einem Aktorfkopf 6 und einem Aktorfuß 7 den Piezoaktor 2 bilden. Um den Piezoaktor 2 ist eine hier nur schematisch angedeutete Isolationshülse 8 als Ummantelung gelegt.

Die Piezoelemente 5 wirken bei einer Betätigung, wie sie in der Beschreibungseinleitung anhand eines Piezoinjektors erwähnt ist, über eine sich hier senkrecht unterhalb befindliche mechanische Anordnung mit einem Koppler 9 auf eine Düsennadel 10 derart, dass hier eine Freigabe einer Düsenöffnung 11 erfolgen kann. Ein im Inneren des Piezoinjektors 1 durch den Innenraum 4 des Haltekörpers 3 geführter Kraftstoff kann somit in den Brennraum eines hier nicht dargestellten Verbrennungsmotors injiziert werden.

Im Folgenden werden nun Ausführungsbeispiele von erfindungsgemäßen Anbindungen einer Isolationshülse an entsprechend gestaltete Ausführungen eines Piezoaktors erläutert.

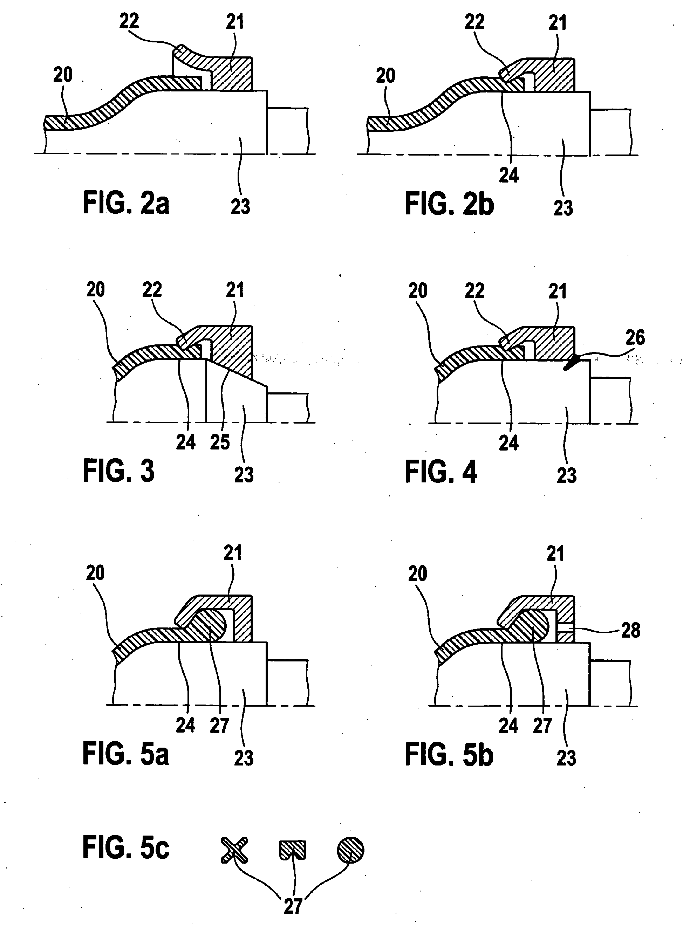

Aus Figur 2a ist ein erstes Ausführungsbeispiel zu entnehmen, bei dem hier, wie bei den folgenden Ausführungsbeispielen, nur der Bereich der Anbindung von Klemmringen an eine Kunststoffhülse als Isolationshülse gezeigt ist. Die Figur 2a zeigt eine Kunststoffhülse 20 aus einem unter Temperatureinwirkung schrumpfbaren Material im auf die Kontur des Piezoaktors aufgeschrumpften Zustand und einen Klemmring 21, der mittels einer verstemmbaren Klemmnase 22 die eingeschobene Kunststoffhülse 20 aufnimmt. Der Klemmring 21 ist auf einem metallischen Aktorfuß 23 des Piezoaktors (vgl. Aktorfuß 7 des Piezoaktors 2 aus der Figur 1) mittels Flächenpaarung z. B. über einen hier nicht dargestellten O-Ring aufgeschoben und fixiert.

Figur 2b zeigt das zuvor beschriebene Ausführungsbeispiel mit einer bereits verstemmten Klemmnase 22, die in die Kunststoffhülse 20 eindringt und dadurch eine Dichtfläche 24 bildet.

Aus Figur 3 ist eine Abwandlung der zuvor beschriebenen Ausführungsform zu sehen, bei der der Klemmring 21, anstatt auf einer zylindrischen Form, auf einer mit flachem Winkel konischen Abschrägung 25 des Aktorfußes 23 selbsthemmend sitzt. Hier sind jedoch auch andere geometrische Gestaltungen denkbar, die selbsthemmend wirken. Durch diesen Selbsthemmungseffekt sind eventuell zusätzliche Schweißverbindung oder sonstige Befestigungsmaßnahmen überflüssig, wobei hier auch noch zusätzlich eine Glaseinschmelzung angebracht werden kann. Figur 4 zeigt darüber hinaus noch die eventuell notwendige zusätzliche Anbringung einer Schweiß- oder Lötnaht 26 zwischen dem Klemmring 21 und dem Fußteil 23.

In Figur 5a ist ein Ausführungsbeispiel gezeigt, bei dem der Klemmring 21 einen Hohlraum zur Aufnahme einer Verdickung 27 der Kunststoffhülse 20 aufweist, durch die zusätzlich zur Wirkung der Dichtfläche 24 noch ein erhöhter sicherer Halt der Kunststoffhülse 20 im Klemmring 21 erreichbar ist. Figur 5b zeigt eine Abwandlung mit einer Druckausgleichbohrung 28 zum Hohlraum des Klemmrings 21 und Figur 5c zeigt beispielhafte weitere Gestaltungsmöglichkeiten der Verdickung 27.

Wird das Ende der Kunststoffhülse 20, wie anhand der Figuren 5a bis 5c beschrieben, in einer O-Ring ähnlichen Form angedickt, so kann durch die Form des Hohlraumes im Klemmring 21 ein Kammern der Kunststoffhülse 20 erreicht werden. Sollte die Kunststoffhülse 20 ein Quellverhalten aufweisen, so wird durch das zuvor beschriebene Kammern eine zusätzliche positive Dichtwirkung erreicht. Das Quellverhalten und das Nachfedern von Beißkanten der Klemmnasen 22 (vgl. Figuren 2a,2b,3,4,5a, 5b) kann mögliche Ermüdungserscheinungen, wie fließen, verminderte Elastizität, etc., am Material der Kunststoffhülse 20 ausgleichen. Das Andicken und Vorkonfektionieren (vgl. 5a bis 5c) kann auf einfache und kostengünstige Weise in vorgeschalteten Arbeitsschritten erreicht werden, wobei neben dem Andicken auch Formelemente zur Bildung der Verdickungen 27 an die Kunststoffhülse 20 anvulkanisiert werden können.

Das verbleibende Luftvolumen zwischen dem Ende der Kunststoffhülse 20 und dem Klemmring 21 sollte dabei so klein wie möglich gehalten werden, um ein Herausdrücken der Kunststoffhülse 20 aus der Beißkante bei einem Druckaufbau im Volumen minimieren zu können. Es ist jedoch zu erwarten, dass es zu keinem Zeitpunkt zu einem höheren Druck im Volumen als im umgebenden System kommen kann. Sollte dies jedoch der Fall sein, so kann das Volumen beispielsweise über die anahnd der Figur 5b beschriebene Druckausgleichsbohrung 28 an den Umgebungsdruck angepasst und somit druckausgeglichen angebunden werden.

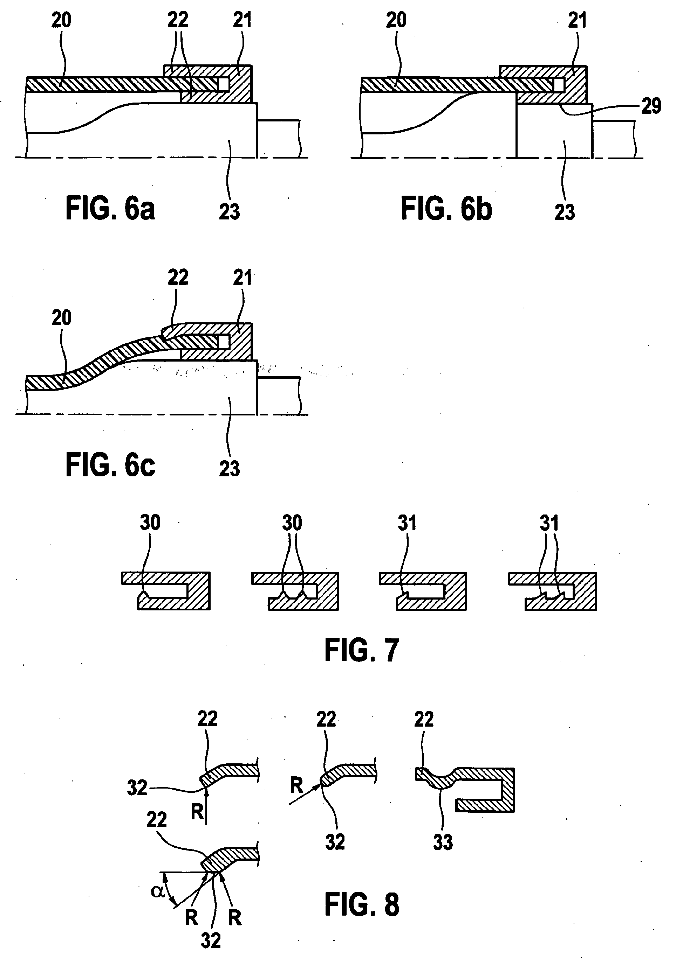

Weitere Möglichkeiten der Ausbildung der Anbindung zwischen dem Klemmring 21 und der Kunststoffhülse 20 sind in den Figuren 6a, 6b und 6c gezeigt. Hier ist die Kunststoffhülse 20 zunächst in Figur 6a und 6b im ungeschrumpften Zustand gezeigt und wird zwischen zwei Klemmnasen 22 des Klemmrings 21 eingepresst. Die Figur 6b zeigt eine Möglichkeit den Klemmring 21 platzsparend in einem Absatz 29 des Aktorfußes 23 zu versenken und Figur 6c zeigt noch die aufgeschrumpfte Kunststoffhülse 20 und die darauf verstemmte obere Klemmnase 22.

Figur 7 zeigt vier Ausführungsbeispiele der Klemmnasen 22 des Klemmrings 21 (vgl. Figur 6a bis 6c) mit innen liegenden Wülsten 30 oder mit Widerhaken 31, die ein Herausrutschen der Kunststoffhülse 20 verhindern sollen. Die Nut bzw. der Raum zwischen den Klemmnasen 22 nach der Figur 7 dient als Führung und Vorzentrierung der Kunststoffhülse 20 bei einem einschrittigen Montagekonzept der Kunststoffhülse 20 im Klemmring 21.

In Figur 8 sind noch weitere vier Abwandlungen der Klemmnasen 22 zu sehen, die am vorderen Ende so gestaltet sind, dass hier Beiß- und Dichtkanten 32 oder ein Federelement 33 entsteht. Die in der Figur 8 gezeigten Klemmnasen 22 mit den Beiß- und Dichtkanten 32 und 33 verhindern, dass beim Schrumpfvorgang die Kunststoffhülse 20 aus dem Klemmring 21 gezogen wird. Je nach Auslegung der Flächenpaarung zwischen dem Klemmring 21 und dem Metall am Aktorfuß oder am Aktorkopf, hier der Aktorfuß 23, wird der Klemmring beim Schrumpfen in Längsrichtung verschoben und ein Herausziehen der Kunststoffhülse 20 aus dem Klemmring 21 unterbunden.

Die eigentliche Dichtwirkung wird bei den gezeigten Ausführungsbeispielen an den durch die jeweilige Beiß- und Dichtkante (vgl. 32 und 33 aus der Figur 8) angedrückten Dichtflächen 24 (vgl. Figur 2b) zwischen der Kunststoffhülse 20 und dem metallischen Aktorkopf oder dem Aktorfuß 23 erzeugt. Zusätzlich sorgen die Beiß- und Dichtkanten 32 oder 33, welche in einem Folgearbeitsschritt nach dem Aufpressen des Klemmrings 21 in das Material der Kunststoffhülse 20 gedrückt werden und einen hochdruckdichten Formschluss erzeugen, für weitere Dichtstellen, die zu einer Erhöhung der Sicherheit gegen einen Medieneintritt bieten. Gleichzeitig wird die Kunststoffhülse 20 in diesem Bereich durch die Beiß- und Dichtkanten 32, 33 sowie die Klemmnasen 22 an ihrer Position gehalten.

Die anhand der Figuren dargestellten Klemmringe 21 und deren Anbindung an den Aktorfuß 23 und die Kunststoffhülse 20 können noch mit zusätzlichen, hier nicht immer explizit dargestellten Merkmalen versehen werden. Hierbei ist es vorteilhaft, wenn ein Verbindungspartner, vorzugsweise der Klemmring 21, eine weiche, leicht verformbare, z. B. vergoldete Oberfläche auf einem elastischen metallischen Grundträger erhält. Diese weiche Oberflache sorgt für eine hohe Dichtwirkung aufgrund des plastischen Formschlusses in den Oberflächenstrukturen der Fügepartner Aktorfuß oder Aktorkopf und Klemmring 21.

Um Platz zu sparen, können der metallische Aktorkopf oder der Aktorfuß mit Absätzen oder Vertiefungen versehen werden, um den radialen Aufbau zu minimieren. Dies ist vor allem bei der vormontierten und aufgeschobenen Variante der Klemmringe 21 nach den Figuren 2a bis 6c hilfreich, da hier die Kunststoffhülse 20 in einem vorgeschalteten Arbeitsgang mit dem Klemmring 21 gefügt und über die Vertiefung exakt positioniert werden kann. Dies sorgt besonders in der Großserienfertigung für eine erhebliche Montageerleichterung.

## Patentansprüche

1. Piezoaktor (2) mit zwischen einem Aktorkopf und einem Aktorfuß eingespannten Piezoelementen (5) und einer mindestens die Piezoelemente (5) umgebenden Isolationshülse (8), wobei die Isolationshülse eine Kunststoffhülse (20) ist, die am zylindrischen Aktorkopf und/oder am Aktorfuß (23) des Piezoaktors in einen zylindrischen Klemmring (21) eingefasst ist, wobei
der jeweilige Klemmring (21) ein Metallteil oder ein Kunststoffteil ist, das mit zur Einfassung der Kunststoffhülse (20) geeigneten Klemmnasen (22) ausgestattet ist und auf den jeweiligen Aktorkopf und/oder Aktorfuß (23) des Piezoaktors aus Stahl aufgeschoben, aufgepresst oder aufgeschrumpft ist, und
wobei der jeweilige Klemmring (21) vorzentriert oder vororientiert ist und zusätzlich am Aktorkopf und/oder am Aktorfuß (23) verschweißt, verlötet oder verklebt ist.

2. Piezoaktor nach Anspruch 1 **dadurch gekennzeichnet, dass** die Kunststoffhülse (20) aus einem unter Temperatureinwirkung schrumpfbaren Material ist.

3. Piezoaktor nach Anspruch 2, **dadurch gekennzeichnet, dass** die Kontur des Aktorkopfs und/oder des Aktorfußes (23) des Piezoaktors in Richtung der Piezoelemente verjüngt ist und sich die aufgeschrumpfte Kunststoffhülse (20) daran anschmiegt.

4. Piezoaktor nach einem der vorhergehenden Ansprüche, **dadurch gekennzeichnet, dass** die Kunststoffhülse (20) im Bereich oder in der Nähe der Klemmung mit dem Klemmring (21) zumindest teilweise eine selbsthemmende Oberfläche aufweist.

5. Piezoaktor nach Anspruch 4, **dadurch gekennzeichnet, dass** die selbsthemmende Oberfläche aus einer Glaseinschmelzung oder Glasklebung besteht.

6. Piezoaktor nach Anspruch 4, **dadurch gekennzeichnet, dass** die selbsthemmende Oberfläche aus ringförmigen Absätzen oder Vertiefungen besteht.

7. Piezoaktor nach einem der Ansprüche 4 bis 6, **dadurch gekennzeichnet, dass** der jeweilige Klemmring (21) auf der dem Aktorkopf und/oder dem Aktorfuß (23) zugewandten Seite eine weiche Beschichtung aufweist.

8. Piezoaktor nach einem der vorhergehenden Ansprüche, **dadurch gekennzeichnet, dass** der jeweilige Klemmring (21) auf einem konisch auf der den Piezoelementen abgewandten Seite abgeschrägten (Abschrägung 25) Aktorkopf und/oder Aktorfuß (23) des Piezoaktors aufliegt.

9. Piezoaktor nach einem der vorhergehenden Ansprüche, **dadurch gekennzeichnet, dass** mindestens eine der Klemmnasen (22) des jeweiligen Klemmrings (21) Widerhaken (30,31), Beiß- oder Dichtkanten (32,33) aufweist, die ein Herausrutschen der Kunststoffhülse (20) aus dem Klemmring (21) verhindern.

10. Piezoaktor nach einem der vorhergehenden Ansprüche, **dadurch gekennzeichnet, dass** die äußere Klemmnase (22) vor dem Einführen der Kunststoffhülse (20) nach außen gebogen ist und nach dem Einführen der Kunststoffhülse (20) durch Verstemmen auf die Kunststoffhülse (20) drückbar ist.

11. Piezoaktor nach einem der vorhergehenden Ansprüche, **dadurch gekennzeichnet, dass** die Kunststoffhülse (20) im Bereich des Einschlusses durch den jeweiligen Klemmring (21) eine vorgefertigte oder nachträglich herbeigeführte Verdickung (27) aufweist, die in einem entsprechend geformten gegebenenfalls mit einer Druckausgleichsbohrung (28) versehenen Hohlraum des Klemmringes (21) zu liegen kommt.

12. Piezoaktor nach einem der vorhergehenden Ansprüche, **dadurch gekennzeichnet, dass** der Piezoaktor Bestandteil eines Piezoinjektors mit direkter Nadelansteuerung für ein Einspritzsystem für Kraftstoff bei einem Verbrennungsmotor ist, wobei der Kraftstoff unter Hochdruck die Kunststoffhülse (20) umströmt.

## Claims

1. Piezo actuator (2) with piezo elements (5) clamped between an actuator head and an actuator base and with an insulating sleeve (8) surrounding at least the piezo elements (5), the insulating sleeve being a plastic sleeve (20) which is enclosed in a cylindrical clamping ring (21) at the cylindrical actuator head and/or at the actuator base (23) of the piezo actuator, the respective clamping ring (21) being a metal part or a plastic part which is provided with clamping lugs (22) suitable for enclosing the plastic sleeve (20) and is pushed, pressed or shrunk on the respective actuator head and/or actuator base (23) of the steel piezo actuator, and the respective clamping ring (21) being pre-centred or pre-oriented and additionally welded, brazed, soldered or adhesively bonded to the actuator head and/or to the actuator base (23).

2. Piezo actuator according to Claim 1, **characterized in that** the plastic sleeve (20) is made of a material that can be made to shrink by the effect of temperature.

3. Piezo actuator according to Claim 2, **characterized in that** the contour of the actuator head and/or the actuator base (23) of the piezo actuator is narrowed in the direction of the piezo elements and is closely followed by the shrunk-on plastic sleeve (20).

4. Piezo actuator according to one of the preceding claims, **characterized in that** the plastic sleeve (20) has at least partially an automatically interlocking surface in the region or the vicinity of where it is clamped by the clamping ring (21).

5. Piezo actuator according to Claim 4, **characterized in that** the automatically interlocking surface comprises a glass fusion or glass bond.

6. Piezo actuator according to Claim 4, **characterized in that** the automatically interlocking surface comprises annular offsets or depressions.

7. Piezo actuator according to one of Claims 4 to 6, **characterized in that** the respective clamping ring (21) has a soft covering on the side facing the actuator head and/or the actuator base (23).

8. Piezo actuator according to one of the preceding claims, **characterized in that** the respective clamping ring (21) rests on an actuator head and/or actuator base (23) of the piezo actuator that is conically bevelled on the side facing away from the piezo elements (bevel 25).

9. Piezo actuator according to one of the preceding claims, **characterized in that** at least one of the clamping lugs (22) of the respective clamping ring (21) has barbs (30, 31), biting edges or sealing edges (32, 33), which prevent the plastic sleeve (20) from slipping out of the clamping ring (21).

10. Piezo actuator according to one of the preceding claims, **characterized in that**, before insertion of the plastic sleeve (20), the outer clamping lug (22) is bent outwards and, after insertion of the plastic sleeve (20), it can be pressed onto the plastic sleeve (20) by caulking.

11. Piezo actuator according to one of the preceding claims, **characterized in that** the plastic sleeve (20) has, in the region where it is surrounded by the respective clamping ring (21), a prefabricated or subsequently produced thickening (27), which comes to lie in a correspondingly formed cavity of the clamping ring (21) that may be provided with a pressure-equalizing bore (28).

12. Piezo actuator according to one of the preceding claims, **characterized in that** the piezo actuator is a component part of a piezo injector with direct needle activation for a fuel injection system in an internal combustion engine, fuel flowing around the plastic sleeve (20) under high pressure.

## Revendications

1. Actionneur piézoélectrique (2) comprenant des éléments piézoélectriques (5) serrés entre une tête d'actionneur et une base d'actionneur et une gaine isolante (8) entourant au moins les éléments piézoélectriques (5), la gaine isolante étant une gaine en plastique (20) qui est encastrée dans une bague de serrage cylindrique (21) au niveau de la tête d'actionneur cylindrique et/ou au niveau de la base d'actionneur (23) de l'actionneur piézoélectrique,
la bague de serrage (21) respective étant une pièce métallique ou une pièce en plastique, qui est munie de nez de serrage (22) approprié pour encastrer la gaine en plastique (20), et qui est poussée, pressée ou emmanchée sur la tête d'actionneur et/ou la base d'actionneur (23) respective de l'actionneur piézoélectrique en acier, et
la bague de serrage respective (21) étant pré-centrée ou pré-orientée et étant en outre soudée, brasée ou collée à la tête d'actionneur et/ou à la base d'actionneur (23).

2. Actionneur piézoélectrique selon la revendication 1, **caractérisé en ce que** la gaine en plastique (20) est un matériau pouvant subir un retrait sous l'effet de la température.

3. Actionneur piézoélectrique selon la revendication 2, **caractérisé en ce que** le contour de la tête d'actionneur et/ou de la base d'actionneur (23) de l'actionneur piézoélectrique est rétréci dans la direction des éléments piézoélectriques, et la gaine en plastique (20) emmanchée à chaud s'y ajuste étroitement.

4. Actionneur piézoélectrique selon l'une quelconque des revendications précédentes, **caractérisé en ce que** la gaine en plastique (20) présente dans la région ou à proximité du serrage avec la bague de serrage (21), au moins en partie une surface autobloquante.

5. Actionneur piézoélectrique selon la revendication 4, **caractérisé en ce que** la surface autobloquante se compose d'un joint de verre ou d'un collage de verre.

6. Actionneur piézoélectrique selon la revendication 4, **caractérisé en ce que** la surface autobloquante se compose d'épaulements ou de retraits de forme annulaire.

7. Actionneur piézoélectrique selon l'une quelconque des revendications 4 à 6, **caractérisé en ce que** la bague de serrage respective (21) présente un revêtement tendre sur le côté tourné vers la tête d'actionneur et/ou la base d'actionneur (23).

8. Actionneur piézoélectrique selon l'une quelconque des revendications précédentes, **caractérisé en ce que** la bague de serrage respective (21) repose sur une tête d'actionneur et/ou une base d'actionneur (23) de l'actionneur piézoélectrique biseautée (biseau 25) en forme conique du côté opposé aux éléments piézoélectriques.

9. Actionneur piézoélectrique selon l'une quelconque des revendications précédentes, **caractérisé en ce qu'**au moins l'un des nez de serrage (22) de la bague de serrage respective (21) présente des barbes (30, 31), des arêtes d'attaque ou des arêtes d'étanchéité (32, 33), qui empêchent la gaine en plastique (20) de glisser hors de la bague de serrage (21).

10. Actionneur piézoélectrique selon l'une quelconque des revendications précédentes, **caractérisé en ce que** le nez de serrage extérieur (22) est cintré vers l'extérieur avant l'introduction de la gaine en plastique (20), et peut être pressé par matage sur la gaine en plastique (20) après l'introduction de la gaine en plastique (20).

11. Actionneur piézoélectrique selon l'une quelconque des revendications précédentes, **caractérisé en ce que** la gaine en plastique (20) présente, dans la région de l'inclusion à travers la bague de serrage respective (21), un épaississement (27) préfabriqué ou réalisé ultérieurement, qui vient se placer dans une cavité de la bague de serrage (21) de forme correspondante et éventuellement pourvue d'un alésage de compensation de la pression (28).

12. Actionneur piézoélectrique selon l'une quelconque des revendications précédentes, **caractérisé en ce que** l'actionneur piézoélectrique fait partie d'un injecteur piézoélectrique avec commande de pointeau directe pour un système d'injection de carburant dans un moteur à combustion interne, le carburant circulant à haute pression autour de la gaine en plastique (20).
